(19) Europäisches Patentamt
European Patent Office
Office européen des brevets

(11) **EP 3 609 078 A1**

(12) **EUROPEAN PATENT APPLICATION**

(43) Date of publication:
**12.02.2020 Bulletin 2020/07**

(51) Int Cl.:
**H03M 1/08** *(2006.01)*  **H03M 1/86** *(2006.01)*
**H03M 3/00** *(2006.01)*

(21) Application number: **18306078.9**

(22) Date of filing: **06.08.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Nokia Solutions and Networks Oy 02610 Espoo (FI)**

(72) Inventors:
• **JENNEVE, Philippe**
  **91620 NOZAY (FR)**
• **LAYEC, Patricia**
  **91620 NOZAY (FR)**
• **ALMONACIL, Sylvain**
  **91620 NOZAY (FR)**

(74) Representative: **Croonenbroek, Thomas Jakob et al**
  **Innovincia**
  **11, avenue des Tilleuls**
  **74200 Thonon-les-Bains (FR)**

(54) **METHOD FOR PROCESSING QUANTIZATION NOISE AND ASSOCIATED EQUIPMENT**

(57) The present invention refers to a method for processing quantization noise in an optical network transmitter (1) comprising a digital to analog converter (7) wherein digital quantization is applied to the signal to be converted in the digital to analog converter (7), the digital quantization producing a signal with a N bit resolution from a signal with a M bit resolution, M being higher than N, with the N bit resolution corresponding to the capacity of the digital to analog converter (7) and wherein noise shaping filtering is applied to the digital quantization.

Fig.2

**Description**

## TECHNICAL FIELD

The present invention relates to the field of optical transmission networks and in particular to the processing of the quantization noise in order to improve the signal to noise ratio of the transmitted optical signals.

## BACKGROUND OF THE INVENTION

Quantization refers to the change of resolution between the input signal and the output signal of a converter such as a digital to analog converter in an optical network.

Such quantization introduces noise, herein called quantization noise, which is created by the difference between the input signal value and the output signal value. Such quantization noise affects the signal to noise ratio.

In order to reduce the effect of the quantization noise, techniques have been developed in order to process and reduces this quantization noise. Such techniques are based for example on a feedback loop between the output and the input of the converter introducing the quantization.

Such techniques require the comparison between the input and the output of the converter to determine the quantization error and combines it with the input signal so that an analog to digital converter as well as processing means are needed at the transmitter side (to implement the said feedback loop). Such converter, which needs to have a higher or equal resolution than the (digital to analog) converter used to convert the transmitted signal, and such processing means are expensive and power consuming. Furthermore, such solutions are difficult to implement for high bitrate signals used in the current optical networks such as signals of 100 Gb/s or higher.

## SUMMARY OF THE INVENTION

It is therefore a goal of the present example embodiments to overcome at least partially the drawbacks of the solutions of the state of the art and to propose a quantization noise processing technique which is less expensive and less power consuming than the existing solutions known in the art.

Thus, the example embodiments refer to a method for processing quantization noise in an optical network transmitter comprising a digital to analog converter wherein digital quantization is applied to the signal to be converted in the digital to analog converter, the digital quantization producing a signal with a N bit resolution from a signal with a M bit resolution, M being higher than N, with the N bit resolution corresponding to the capacity of the digital to analog converter and wherein noise shaping filtering is applied to the digital quantization.

According to another aspect of the present example embodiments, the digital quantization is achieved by a single-stage quantizer wherein each sample of the M bits resolution digital signal is converted into the sample having the nearest quantization level of the N bits resolution digital signal.

According to a further aspect of the present example embodiments, the digital signal comprises a data band smaller than the digital to analog converter spectral bandwidth and a guard band corresponding to the difference between the digital to analog converter (7) bandwidth and the data band and wherein the noise shaping filtering produces at least a partial shifting of the quantization noise from the data band to the guard band.

According to an additional aspect of the present example embodiments, the ratio between the data band of the digital signal and the digital to analog converter spectral bandwidth, corresponding to the inverse of the oversampling ratio, is smaller than 0,9.

According to another aspect of the present example embodiments, the noise shaping filtering comprises the following steps:

- computing a quantization error of the digital quantization,
- computing filtering taps based on the sampling rate of the digital to analog converter, the data rate and the roll-off factor of the signal to be transmitted,
- computing corrected quantization error components by applying the computed filtering taps to the computed quantization error,
- computing a correction factor by summing the computed corrected quantization error components,
- adding the computed correction factor to the signal to be converted upstream of the digital quantization.

According to a further aspect of the present example embodiments, the filtering taps are computed based on a weighted least-square method.

According to an additional aspect of the present example embodiments, the filtering taps are chosen so that the poles of the transfer function of the noise shaping filtering are located within the unit circle in order to ensure stability of the noise shaping filtering.

The present example embodiments also refer to a digital processing equipment configured to be implemented in an optical network transmitter comprising a digital to analog converter and for processing quantization noise wherein the said digital processing equipment comprises a digital quantizer and a noise shaping filtering feedback loop between an output and an input of the digital quantizer.

According to another aspect of the present example embodiments, the noise shaping filtering feedback loop comprises a memory for saving a quantization error of a given digital signal sample and a processing unit configured for computing filtering taps to be applied to the quantization error to produce corrected quantization error components and wherein the digital processing equipment is configured for computing a correction factor comprising the sum of the corrected quantization error components and for adding the computed correction factor to the next digital signal sample.

According to a further aspect of the present example embodiments, the values of the filtering taps remain identical for a given sampling rate of the digital to analog converter and for a given data rate and a given roll-off factor of the signal to be converted.

According to an additional aspect of the present example embodiments, the number of filtering taps is comprised between 3 and 15 and is chosen according to the targeted signal to noise ratio gain.

## BRIEF DESCRIPTION OF THE DRAWINGS

FIG.1 is a simplified diagram of a transmitter of an optical network;

FIG.2 is a diagram of a digital quantizer and digital quantization processing means according to the present example embodiments;

FIG.3 is a flowchart of the steps of the method according to the present example embodiments;

FIG.4 is a plot of the power spectral density of the quantization noise of two signals, one without the application of a noise filter and the other one with the application of a noise filter.

## DETAILED DESCRIPTION OF THE INVENTION

The following achievements are examples. Although, the specification refers to one or several embodiments, it does not imply that each reference refers to the same embodiment or that the features apply only to a single embodiment. Simple features of different embodiments can also be combined to provide other embodiments.

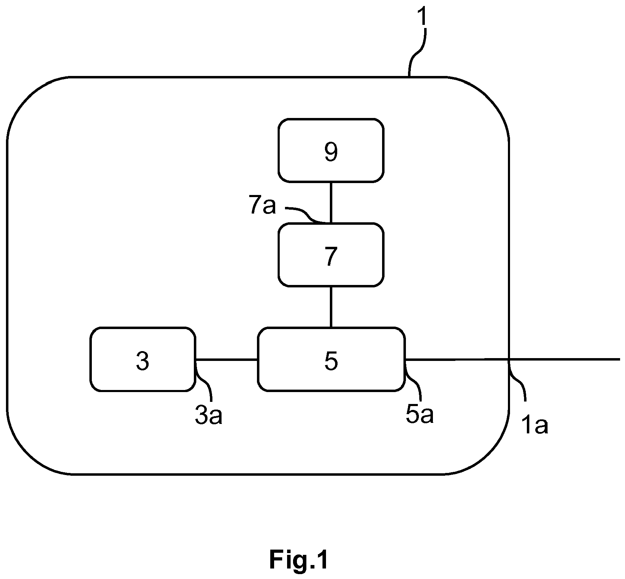

Fig.1 represents an optical transmitter 1 configured for transmitting optical signals in an optical network.

The optical transmitter 1 comprises a laser source 3, for example a tunable laser source or a fixed laser source, having an output 3a coupled to a modulator 5. The modulator 5 is configured for modulating the optical signal emitted by the laser source 3 according to a data signal provided by a digital to analog converter 7. The modulator 5 is for example a Mach-Zehnder modulator or an electro-absorption modulator. The input 7a of the digital to analog converter 7 is coupled to a digital processing unit 9. The digital processing unit 9 may comprise a processor and/or an integrated circuit and/or a memory. At the output 5a of the modulator 5, the modulated signal is then transmitted toward the output 1a of the optical transmitter 1.

In order to avoid the production of a quantization at the digital to analog converter 7, a digital quantizer 11 is implemented in the digital processing unit 9.

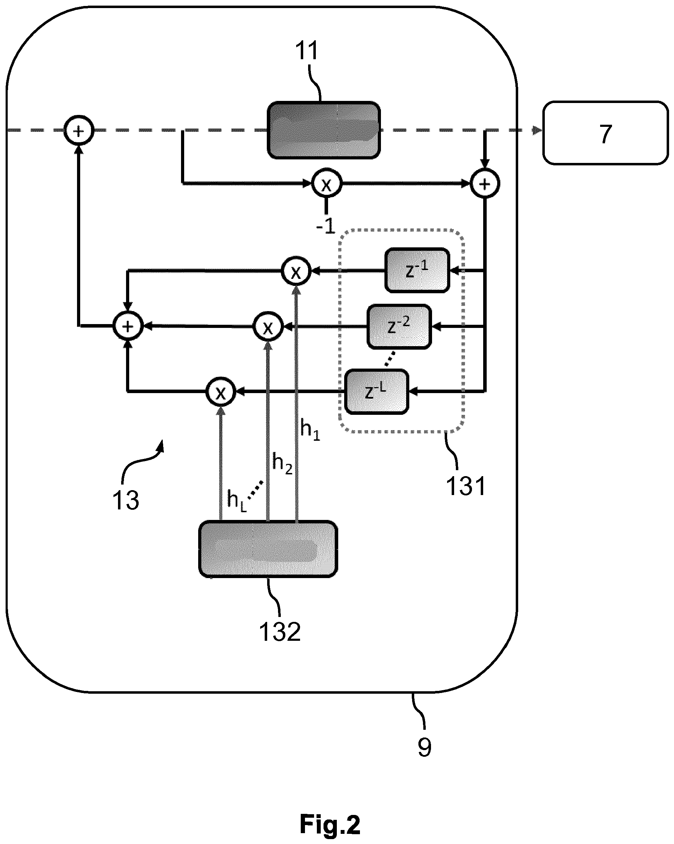

Fig.2 represents a diagram of the digital quantizer 11 and the digital feedback loop 13 enabling processing of the quantization noise induced by the digital quantizer 11.

The digital quantizer 11 is configured for converting a signal having a M bit resolution, for example a 7 bit signal, into a signal having a N bit resolution with N being lower than M (M>N). The N bit resolution is chosen to be at most the capacity of the digital to analog converter 7, for example a 6 bit signal. The digital quantizer 11 is for example a single-stage quantizer wherein each sample of the high resolution digital signal, corresponding to the M bit resolution, is associated with the nearest output quantization level of the digital quantizer 11 which corresponds to the levels of an N bit resolution. As the quantization levels are fixed and known, there no need to know the global channel response to determine the quantization error.

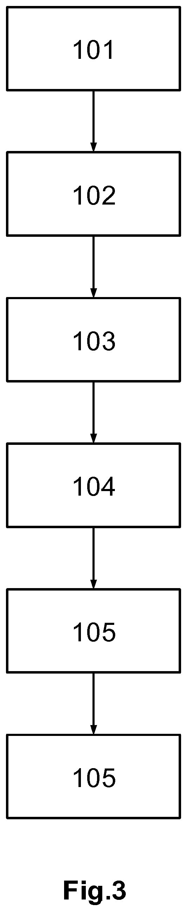

The different steps of the quantization noise filtering will now be described based on the flowchart of Fig.3 and the diagram of Fig.2. Furthermore, it has to be noted that the digital signal to be converted is configured to have a spectral bandwidth comprising a data band smaller than the digital to analog converter 7 spectral bandwidth and a guard band corresponding to the difference between the digital to analog converter 7 spectral bandwidth and the data band, the transmitted signal spectral band comprising the combination of the data band and the guard band. The ratio between the data band and the total bandwidth of the signal (data band and guard band) is smaller than 0,9, for example comprised between 0,7 and 0,9. The total bandwidth of the signal is chosen to match the digital to analog converter 7 bandwidth.

Thus the oversampling ratio, corresponding to the ratio between the digital to analog converter over the data band, is higher than 1,1 for example comprised between 1,1 and 1,4.

Furthermore, in optical transmissions, a root-raised cosine filter (RRC filter) is usually applied to the signals at the transmitter. The signal bandwidth is then equal to the value R*(1+β) with R the data rate and β the roll-off factor introduced by the RRC filter. Thus, the oversampling ratio depends on the data rate, the roll-off factor and the sampling rate of the digital to analog converter so that these three inputs are required to compute the taps of the quantization noise filter.

In a first step 101, a quantization error is computed. Such computation refers to the difference between the output and the input of the digital filter for a given sample.

The second step 102 refers to the storage of the computed quantization error in a memory, for example a memory 131 having a length L where L corresponds to the number of taps of the filter which will be described in the following of the description. The computed quantization error is then stored in the L spaces of the memory 131. The number L of taps is determined based on the targeted value of the signal to noise ratio. A number of taps comprised between 3 and 15 is generally sufficient to obtain a significant improvement in the signal to noise ratio. The number of taps is chosen for example to get the best trade-off between the signal to noise ratio improvement and the required processing capacity.

The third step 103 refers to the computation of the filter taps based on a weighted least-square method to minimize the quantization error of the transfer function produced by the digital quantizer 11.

Such computation is done based on the sampling frequency of the digital to analog converter 7, the data rate and the roll off factor of the signal to be converted.

The transfer function of the digital quantizer 11 and the digital feedback loop 13 can be written as:

$$Y(z) = X(z) + (1+H(z))*E(z) \quad (1)$$

with X(z) the signal at the input of the digital quantizer 11, Y(z) the signal at the output of the digital quantizer 11, E(z) the quantization noise and H(z) the filter transfer function defined by:

$$H(z) = h_1 z^{-1} + h_2 z^{-2} + ... + h_L z^{-L} \quad (2)$$

with $h_1$, $h_2$...$h_L$ the filter taps.

The minimization of the quantization noise effect in the data band is obtained by solving:

$$\min_{h_1, h_2, ... h_L} \sum_{i=1}^{P} \left| 1 + H\left(e^{jw_i}\right) \right|^2 \quad (3)$$

wherein $1+H(e^{jwi})$ can be rewritten in a matrix form:

$$\overline{1} + \overline{A}\,\overline{h} = \begin{bmatrix} 1 \\ 1 \\ \cdot \\ \cdot \\ \cdot \\ 1 \end{bmatrix} + \begin{bmatrix} e^{-jw_1} + e^{-2jw_1} + ... + e^{-Ljw_1} \\ e^{-jw_2} + e^{-2jw_2} + ... + e^{-Ljw_2} \\ \cdot \\ \cdot \\ \cdot \\ e^{-jw_s} + e^{-2jw_s} + ... + e^{-Ljw_s} \end{bmatrix} \begin{bmatrix} h_1 \\ h_2 \\ \cdot \\ \cdot \\ \cdot \\ h_L \end{bmatrix} \quad (4)$$

The minimization must be done under the constraint that all the coefficients $h_i$ are real. However, the matrix A is a complex valued matrix. The matrix A can be rewritten by separating its real and imaginary parts. Equation (3) becomes:

$$\min_g \left\| \overline{1} + \overline{A}\,\overline{h} \right\|^2 = \min_h \left\| \begin{bmatrix} \overline{1} \\ \overline{0} \end{bmatrix} + \begin{bmatrix} \overline{A_r} \\ \overline{A_i} \end{bmatrix} \overline{h} \right\|^2 \quad (5)$$

with $A_r$ the real part of A and $A_i$ the imaginary part of A.
The solution to the equation (5) is given by:

$$h_{opt} = -\left[\frac{\overline{A_r}}{\overline{A_i}}\right]^{[-1]}\left[\frac{\overline{1}}{\overline{0}}\right] \quad (6)$$

with $A^{[-1]}$ corresponding to the pseudo-inverse of A.

This solution $h_{opt}$ gives a noise transfer function 1+H(z) with a strong noise attenuation in the data band but a high attenuation of the quantization noise in the data band unavoidably increases the gain in the guard band which can lead to a saturation of the quantizer 11 (if the feedback signal has an amplitude greater than the quantizer 11 dynamic) and to instability of the feedback loop 13.

In order to overcome this problem a weighting matrix W is introduced in order to limit the values of $|1+H(e^{jw})|$ in the guard band.

The weighting matrix W is diagonal matrix with the coefficients $W_1$, $W_2$,...$W_P$, $W_{P+1}$...$W_{P+Q}$ as diagonal coefficients where the coefficients $W_1$ to WP correspond to the coefficients associated with the data band and the $W_{P+1}$...$W_{P+Q}$ correspond to the coefficients associated to the guard band. All the coefficients are positive but the coefficients $W_1$ to WP are equal to Ws and the coefficients $W_{P+1}$ to $W_{P+Q}$ are equal to Wr with Ws>Wr. The introduction of such weighting matrix in equation (5) leads to:

$$\min_{h}\left\|\overline{W}\left(\overline{1}+\overline{A}\ \overline{h}\right)\right\|^2 \quad (7)$$

and the solution to equation (7) is given by:

$$h_{opt} = -\left[\overline{W'}\left[\frac{\overline{A_r}}{\overline{A_i}}\right]\right]^{[-1]}\overline{W'}\left[\frac{\overline{1}}{\overline{0}}\right]$$

with

$$\overline{W'} = \left[\begin{array}{cc}\overline{W} & 0 \\ 0 & \overline{W}\end{array}\right] .$$

Such weighted least square method enables therefore computing a set of tap values noted $h_1$, $h_2$...$h_L$ producing a filtering transfer function wherein the quantization noise is at least partially switched to different frequencies, notably frequencies that are out of the data band of the signal bandwidth, i.e. higher frequencies. The amount of quantization noise remains the same but its distribution among the spectral frequencies is changed in order to reduce the amount of quantization noise within the data band. The quantization noise is then mainly located in the guard band where no data is transmitted.

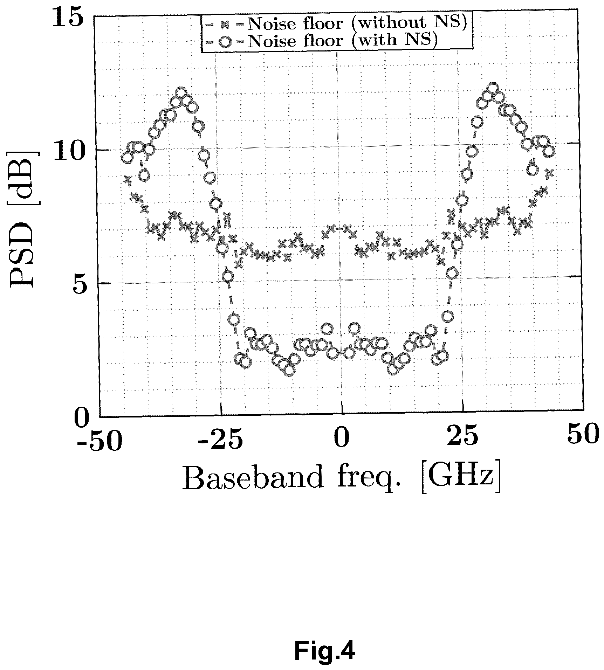

Fig.4 represents the power spectral density (PSD) in function of the baseband frequency with and without the application of a noise shaping (NS) filter such as the noise shaping filter produced by the digital feedback loop 13 in Fig.2. This plot shows the distribution of the quantization noise among the baseband frequencies. When no noise shaping is applied, the distribution is almost homogeneous over the whole spectral bandwidth (between -35 GHz and 35 GHz) and the quantization noise level is located in a range between 6 and 8 dB whereas in the case of the used of noise shaping this distribution can be divided into two main ranges, a first low frequency band (between -20 GHz and 20 GHz) corresponding to the data band wherein the quantization noise level is located in a range around 2-3 dB and a second high frequency band (below -20 GHz and above 20 GHz) corresponding to the guard band and wherein the quantization noise level is located in a range between 4 and 12 dB. Thus, if the data band is set between -20 and 20 GHz and the guard band is set between 20 and 35 GHz for example, the quantization noise in the data band is significantly reduced (up to 4 dB) so that the overall signal to noise ratio of the transmission is significantly improved.

Furthermore, in order to ensure the stability of the filtering, an added constraint is enforced to the poles of the computed transfer function. This stability condition refers to the location of the poles of the computed transfer function within the unit circle. The set of tap values are therefore chosen by taking into account this condition. The tap values remain the same for each configuration (sampling rate, data rate and roll off factor) so that the tap values associated to the different used configurations may be stored in look-up tables in order to limit the computation resources. The number of taps used for the filtering may be chosen according to the oversampling ratio as well as the targeted signal to noise ratio improvement.

This computation of the tap values may be realized by a processor 132 of the digital feedback loop 13.

The fourth step 104 refers to the application of the computed tap values to the stored quantization error by multiplying the quantization error by the tap values to produce L corrected quantization error components.

The fifth step 105 refers to the combination of the L correction factors which are summed together to produce a correction factor.

The sixth step 106 refers to the combination of the correction factor with the next sample by adding the correction factor to the next sample entering the digital quantizer 11.

Thus, the use of a digital quantizer 11 upstream of a digital to analog converter 7 in a transmitter of an optical network enables applying noise shaping filtering in the digital domain and therefore does not require any analog to digital converter. Furthermore, the digital quantizer 11 allows using a single stage quantizer (no need for soft quantizer, the output of the digital quantizer being a scalar). The filtering taps need to be computed only once for each configuration (sampling rate, data rate and roll factor) so that no dynamic algorithm is needed. Finally, the stability of the filtering is ensured by the additional constraint on the computed tap values so that there is no need of tuning the error feedback power nor applying a clipping ratio on the digital to analog converter 7.

**Claims**

1. Method for processing quantization noise in an optical network transmitter (1) comprising a digital to analog converter (7) wherein digital quantization is applied to the signal to be converted in the digital to analog converter (7), the digital quantization producing a signal with a N bit resolution from a signal with a M bit resolution, M being higher than N, with the N bit resolution corresponding to the capacity of the digital to analog converter (7) and wherein noise shaping filtering is applied to the digital quantization.

2. Method in accordance with claim 1 wherein the digital quantization is achieved by a single-stage quantizer (11) wherein each sample of the M bits resolution digital signal is converted into the sample having the nearest quantization level of the N bits resolution digital signal.

3. Method in accordance with one of the previous claims wherein the digital signal has a spectral bandwidth comprising a data band smaller than the digital to analog converter (7) spectral bandwidth and a guard band corresponding to the difference between the digital to analog converter (7) bandwidth and the data band and wherein the noise shaping filtering produces at least a partial shifting of the quantization noise from the data band to the guard band.

4. Method in accordance with claim 3 wherein the ratio between the data band of the digital signal and the digital to analog converter (7) spectral bandwidth is smaller than 0,9.

5. Method in accordance with one of the previous claims wherein the noise shaping filtering comprises the following steps:

   - computing a quantization error of the digital quantization, (101)
   - computing filtering taps ($h_1$, $h_2$...$h_L$) based on the sampling rate of the digital to analog converter, the data rate and the roll-off factor of the signal to be transmitted, (103)
   - computing corrected quantization error components by applying the computed filtering taps ($h_1$, $h_2$...$h_L$) to the computed quantization error, (104)
   - computing a correction factor by summing the computed corrected quantization error components,
   - adding the computed correction factor to the signal to be converted upstream of the digital quantization.

6. Method in accordance with claim 5 wherein the filtering taps ($h_1$, h2...hL) are computed based on a weighted least-square method.

7. Method in accordance with claim 5 or 6 wherein the filtering taps ($h_1$, h2...hL) are chosen so that the poles of the transfer function of the noise shaping filtering are located within the unit circle in order to ensure stability of the noise shaping filtering.

8.  Digital processing equipment (9) configured to be implemented in an optical network transmitter (1) comprising a digital to analog converter (7) and for processing quantization noise wherein the said digital processing equipment (9) comprises a digital quantizer (11) and a noise shaping filtering feedback loop (13) between an output and an input of the digital quantizer (11).

9.  Digital processing equipment (9) in accordance with claim 8 wherein the noise shaping filtering feedback loop (13) comprises a memory (131) for saving a quantization error of a given digital signal sample and a processing unit (132) configured for computing filtering taps ($h_1$, $h_2$...$h_L$) to be applied to the quantization error to produce corrected quantization error components and wherein the digital processing equipment (9) is configured for computing a correction factor comprising the sum of the corrected quantization error components and for adding the computed correction factor to the next digital signal sample.

10. Digital processing equipment (9) in accordance with claim 8 or 9 wherein the values of the filtering taps ($h_1$, $h_2$...$h_L$) remain identical for a given sampling rate of the digital to analog converter (7) and for a given data rate and a given roll-off factor of the signal to be converted.

11. Digital processing equipment (9) in accordance with one of the claims from 8 to 10 wherein the number of filtering taps ($h_1$, $h_2$...$h_L$) is comprised between 3 and 15 and is chosen according to the targeted signal to noise ratio gain.

**Fig.1**

**Fig.2**

**Fig.3**

**Fig.4**

Europäisches
Patentamt

European
Patent Office

Office européen
des brevets

# EUROPEAN SEARCH REPORT

Application Number

EP 18 30 6078

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YU ZHENHUA ET AL: "Using delta-sigma modulators in visible light OFDM systems", 2014 23RD WIRELESS AND OPTICAL COMMUNICATION CONFERENCE (WOCC), IEEE, 9 May 2014 (2014-05-09), pages 1-5, XP032608690, DOI: 10.1109/WOCC.2014.6839942 [retrieved on 2014-06-18] * Section II; Section III; figures 2-6 * | 1-11 | INV.<br>H03M1/08<br><br>ADD.<br>H03M1/86<br>H03M3/00 |
| X | YU ZHENHUA ET AL: "Information maximizing DAC noise shaping", 2014 IEEE INTERNATIONAL CONFERENCE ON ACOUSTICS, SPEECH AND SIGNAL PROCESSING (ICASSP), IEEE, 4 May 2014 (2014-05-04), pages 2174-2178, XP032617373, DOI: 10.1109/ICASSP.2014.6853984 [retrieved on 2014-07-11] * Section 3; figures 3-5 * | 1,8 | |
| X | US 7 425 910 B1 (HE RUNSHENG [US] ET AL) 16 September 2008 (2008-09-16) * figures 4-7 * | 1,8 | TECHNICAL FIELDS SEARCHED (IPC)<br><br>H03M |
| A | DICK C ET AL: "Virtual signal processors", MICROPROCESSORS AND MICROSYSTEMS, IPC BUSINESS PRESS LTD. LONDON, GB, vol. 22, no. 3-4, 28 August 1998 (1998-08-28), pages 135-148, XP004146588, ISSN: 0141-9331, DOI: 10.1016/S0141-9331(98)00073-8 * Section 5.1; figure 15 * | 1-11 | |

The present search report has been drawn up for all claims

| Place of search | Date of completion of the search | Examiner |
|---|---|---|
| The Hague | 25 February 2019 | Jesus, Paulo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 30 6078

This annex lists the patent family members relating to the patent documents cited in the above-mentioned European search report.
The members are as contained in the European Patent Office EDP file on
The European Patent Office is in no way liable for these particulars which are merely given for the purpose of information.

25-02-2019

| Patent document cited in search report | Publication date | Patent family member(s) | Publication date |
|---|---|---|---|
| US 7425910 B1 | 16-09-2008 | US 7425910 B1 | 16-09-2008 |
| | | US 7436337 B1 | 14-10-2008 |
| | | US 7471225 B1 | 30-12-2008 |
| | | US 7773017 B1 | 10-08-2010 |
| | | US 7999711 B1 | 16-08-2011 |

EPO FORM P0459

For more details about this annex : see Official Journal of the European Patent Office, No. 12/82